# EUROPEAN PATENT APPLICATION

(11) **EP 1 247 876 A2**
(43) Date of publication of application: **09.10.2002**
(21) Application number: 02007249.2
(22) Date of filing: 28.03.2002
(51) Int. Cl.: C23C 16/40, H01L 21/00

(54) **Method for manufacturing a semiconductor device**

(30) Priority: 05.04.2001 JP 2001106689
(71) Applicant: Canon Sales Co., Inc., Minato-ku, Tokyo 108-0073 (JP); Semiconductor Process Laboratory Co., Ltd., Minato-ku, Tokyo 108-0075 (JP)
(72) Inventor: Shioya, Yoshimi, 2-13-29 Konan, Minato-ku, Tokyo 108-0075 (JP); Ohira, Kouichi, 2-13-29 Konan, Minato-ku, Tokyo 108-0075 (JP); Maeda, Kazuo, 2-13-29 Konan, Minato-ku, Tokyo 108-0075 (JP); Suzuki, Tomomi, Minato-ku, Tokyo 108-0073 (JP)
(74) Representative: Schwabe - Sandmair - Marx

(57) **Abstract**

The present invention relates to a manufacturing method of a semiconductor device on which a barrier insulating film that coats a wiring, particularly a copper wiring, is formed. The configuration of the method includes the steps of: transforming film forming gas containing tetraethoxysilane (TEOS) and nitrogen monoxide (N₂O) into plasma to cause reaction; and forming a barrier insulating film 35a, 39 that coats a copper wiring 34, 38 on a substrate 31 where the copper wiring 34, 38 is exposed on a surface thereof.

## Description

### BACKGROUND OF THE INVENTION

### 1. Field of the Invention

The present invention relates to a manufacturing method of a semiconductor device in which a barrier insulating film that coats a wiring, particularly a copper wiring is formed.

### 2. Description of the Prior Art

In recent years, a higher data transfer speed has been required with higher integration of a semiconductor integrated circuit device. For this reason, a copper wiring is used. In this case, there is a need for an insulating film (hereinafter, referred to as a barrier insulating film) that has a function to prevent diffusion of copper from the copper wiring and a function as an etching stopper when a damascene method is applied, and that preferably has low relative dielectric constant.

To form such a barrier insulating film, there is known a plasma enhanced CVD (Chemical Vapor Deposition) method using mixed gas composed of tetramethylsilane (Si(CH₃)₄), or other types of organic silane, and methane (CH₄).

Alternatively, there is known a silicon nitride film (hereinafter, referred to as an SiN film) deposited by the plasma enhanced CVD method as the barrier insulating film.

However, there exists a problem that the barrier insulating film deposited using tetramethylsilane, or other types of organic silane, and methane has a large content of carbon and a large leakage current. There also exists a problem that the barrier insulating film as the silicon nitride film has relative dielectric constant of about 7 although it has a small leakage current.

### SUMMARY OF THE INVENTION

The object of the present invention is to provide a manufacturing method of a semiconductor device in which a barrier insulating film having low relative dielectric constant of 5 or less and a leakage current characteristic equal to that of a silicon nitride film is deposited.

In this invention, film forming gas that contains tetraethoxysilane (TEOS) and nitrogen monoxide (N₂O) is transformed into plasma to cause reaction to form the barrier insulating film on a substrate.

Experiments resulted in a barrier insulating film having the relative dielectric constant in the 4 range, which is relatively low comparing to the relative dielectric constant of about 7 of the silicon nitride film, and having a small leakage current level equal to that of the silicon nitride film.

Moreover, containing ammonia (NH₃) in the film forming gas of the barrier insulating film results in improving barrier characteristic against copper of the barrier insulating film deposited, and the leakage current can be further reduced.

Furthermore, when hydrocarbon (CₘHₙ): any one of methane (CH₄), acetylene (C₂H₂), ethylene (C₂H₄), and ethane (C₂H₆) for example is added to the film forming gas of the barrier insulating film other than tetraethoxysilane and nitrogen monoxide, or other than tetraethoxysilane, nitrogen monoxide and ammonia (NH₃), a denser barrier insulating film having diffusion preventing capability against copper can be obtained while maintaining low relative dielectric constant.

### BRIEF DESCRIPTION OF THE DRAWINGS

Fig. 1 is a side view showing a configuration of a plasma-enhanced deposition apparatus used in the manufacturing method of the semiconductor device, which is an embodiment of the present invention.
Fig. 2 is a graph showing a relationship between relative dielectric constant of an insulating film deposited and an ammonia flow rate in a deposition method being a first embodiment of the present invention.
Fig. 3 is a graph showing a leakage current of the insulating film deposited by the deposition method being the first embodiment of the present invention.
Fig. 4 is a cross-sectional view showing a sample by which characteristics of the insulating film deposited by the deposition method, which is the first embodiment of the present invention, is inspected.
Figs. 5A to 5D are cross-sectional views showing the semiconductor device and its manufacturing method, which are a second embodiment of the present invention.

### DESCRIPTION OF THE PREFERRED EMBODIMENT

Embodiments of the present invention will be described as follows with reference to the drawings.

### (First Embodiment)

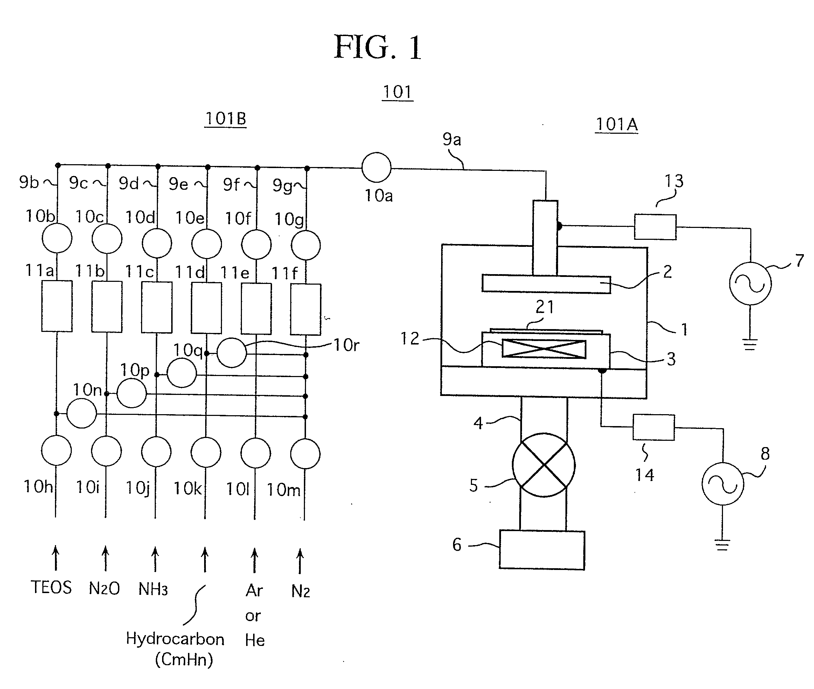

Fig. 1 is the side view showing the configuration of a parallel plate type plasma enhanced CVD apparatus 101 used in the manufacturing method of the semiconductor device according to the embodiment of the present invention.

The plasma enhanced CVD apparatus 101 is provided with: a deposition section 101A that is a position where the insulating film is formed on a substrate subject to deposition 21 by plasma gas; and a film forming gas supply section 101B having a plurality of supply sources of gases that constitute the film forming gas.

The deposition section 101A includes a decompressive chamber 1 as shown in Fig. 1, and the chamber 1 is connected with an exhaust unit 6 via an exhaust piping 4. A switching valve 5 that controls connection/disconnection between the chamber 1 and the exhaust unit 6 is provided halfway the exhaust piping 4. The chamber 1 is provided with pressure measurement means such as a vacuum gauge (not shown) for monitoring a pressure inside the chamber 1.

There is provided in the chamber 1 a pair of an upper electrode (first electrode) 2 and a lower electrode (second electrode) 3, which oppose with each other. A high frequency electric power supply source (RF power source) 7 that supplies high frequency electric power having the frequency of 1 MHz or more, that is, generally 13.56 MHz is connected to the upper electrode 2, and a low frequency electric power supply source 8 that supplies low frequency electric power having the frequency of 100 kHz or more and less than 1 MHz, that is, generally 380 kHz is connected to the lower electrode 3. These power sources (7, 8) supply electric power to the upper electrode 2 and the lower electrode 3 respectively to transform the film forming gas into plasma. The upper electrode 2, the lower electrode 3 and the power sources (7, 8) constitute plasma generation means that transforms the film forming gas into plasma.

The upper electrode 2 also serves as a dispersion unit of the film forming gas. A plurality of through holes are formed on the upper electrode 2, and openings on the opposing side of the through holes to the lower electrode 3 are discharge ports (introduction ports) of the film forming gas. The discharge ports for the film forming gas or the like are connected with the film forming gas supply section 101B by a piping 9a. Further, there are cases where a heater (not shown) is provided for the upper electrode 2. This is because heating the upper electrode 2 to about 100°C during deposition prevents particles made of vapor-phase reaction product such as the film forming gas from adhering to the upper electrode 2.

The lower electrode 3 also functions as a substrate holder for the substrate subject to deposition 21, and it includes a heater 12 that heats the substrate subject to deposition 21 on the substrate holder.

The film forming gas supply section 101B are provided with: a supply source of alkyl compound having siloxane bond; a supply source of tetraethoxysilane (also referred to as tetraethylorthosilicate) (TEOS: Si(OC₂H₅)₄); a supply source of nitrogen monoxide (N₂O); a supply source of ammonia (NH₃); a supply source of hydrocarbon (CₘHₙ); a supply source of dilute gas (Ar or He); and a supply source of nitrogen (N₂).

These gases are appropriately supplied into the chamber 1 of the deposition section 101A through branch piping (9b to 9g) and the piping 9a where all the branch pipings (9b to 9g) is connected. Flow rate adjustment means (11a to 11f) and switching means (10b to 10m) that control open/close of the branch pipings (9b to 9g) are installed halfway the branch pipings (9b to 9g), and switching means 10a that controls open/close of the piping 9a is provided halfway the piping 9a.

Furthermore, switching means (10n, 10p to 10r), which control connection/disconnection between the supply source of nitrogen (N₂) gas and the branch piping 9g connected thereto and other branch pipings (9b to 9e), are installed in order to purge residual gas in the branch piping (9b to 9e) by flowing the nitrogen (N₂) gas. Note that the nitrogen (N₂) gas also purges residual gas in the piping 9a and the chamber 1 other than the branch pipings (9b to 9e).

As described above, the foregoing deposition apparatus 101 is provided with: the supply source of tetraethoxysilane; and the supply source of nitrogen monoxide, and further provided with: the plasma generation means (2, 3, 7 and 8) that transform the film forming gas into plasma.

With this configuration, an insulating film having relatively low relative dielectric constant and the leakage current level equal to that of the silicon nitride film was obtained as shown in the following embodiments. A small leakage current means high barrier characteristic against copper, which is useful as the characteristic of the barrier insulating film that coats the copper wiring.

Moreover, the deposition apparatus further includes: the supply source of ammonia (NH₃) other than the supply source of tetraethoxysilane and the supply source of nitrogen monoxide. Adding ammonia (NH₃) results in further improving the barrier characteristic against copper.

The deposition apparatus further includes the supply source of hydrocarbon (CₘHₙ), which is any one of methane (CH₄), acetylene (C₂H₂), ethylene (C₂H₄), and ethane (C₂H₆) for example other than the supply source of tetraethoxysilane and the supply source of nitrogen monoxide, or other than the supply source of tetraethoxysilane, the supply source of nitrogen monoxide, and the supply source of ammonia (NH₃). An even denser barrier insulating film having low relative dielectric constant can be obtained because the film deposited contains CH₃ due to addition of hydrocarbon (CₘHₙ).

Then, there is provided means for generating plasma by the upper electrode 2 and the lower electrode 3 of a parallel plate type, for example, as the plasma generation means, and the power sources (7, 8) for supplying electric power of two (high and low) frequencies are respectively connected to the upper electrode 2 and the lower electrode 3. Accordingly, the electric power of two (high and low) frequencies is applied to each electrode (2, 3), and thus plasma can be generated. Particularly, the barrier insulating film generated in this manner is dense and has lower relative dielectric constant.

Following is a method of applying the electric power to the upper electrode 2 and the lower electrode 3. Specifically, the low frequency electric power having the frequency of 100 kHz or more and less than 1 MHz is applied only to the lower electrode 3, the low frequency electric power is applied to the lower electrode 3 and the high frequency electric power having the frequency of 1 MHz or more is applied to the upper electrode 2, or the high frequency electric power is applied only to the upper electrode 2.

Next, gas shown below may be used as a typical example of the hydrocarbon and the dilute gas corresponding to the film forming gas to which are applied for the present invention.
(i) Hydrocarbon (CₘHₙ)
   methane (CH₄)
   acetylene (C₂H₂)
   ethylene (C₂H₄)
   ethane (C₂H₆)
(ii) Dilute gas
   Helium (He)
   Argon (Ar)
   Nitrogen (N₂)

Note that the foregoing gases can be variously combined to compose the film forming gas. For example, a film forming gas composed of tetraethoxysilane and nitrogen monoxide, which does not contain ammonia (NH₃), may be used. Alternatively, a film forming gas composed of tetraethoxysilane, nitrogen monoxide and ammonia (NH₃) may also be used.

In addition, hydrocarbon or dilute gas can be further added to the film forming gas of such combinations. In other words, hydrocarbon, that is, any one of methane (CH₄), acetylene (C₂H₂), ethylene (C₂H₄) and ethane (C₂H₆) for example may be further added to the film forming gas of the foregoing combinations. In this case, even denser barrier insulating film can be obtained while maintaining the low relative dielectric constant in the 4 range.

Still further, the foregoing dilute gas is added to the film forming gas, and thus the concentration of silicon-containing gas, ammonia or hydrocarbon can be adjusted.

Next, description will be made for the experiment performed by the inventor.

A silicon oxide film was deposited on an Si substrate by a plasma enhanced CVD method (PECVD method) under the following deposition conditions. Tetraethoxysilane (TEOS), nitrogen monoxide (N₂O) and ammonia (NH₃) were used as the film forming gas.

An insulating film for investigation was deposited by changing the ammonia flow rate among the parameters of deposition conditions in the range of 0 to 250 sccm.

The deposition conditions including the ammonia flow rate are as follows. Note that one minute and thirty seconds are reserved for time (stabilization period) necessary for substituting gas inside the chamber from gas introduction to start of deposition (plasma excitation) during deposition, and the upper electrode 2 is heated to 100°C to prevent the reaction product from adhering to the upper electrode 2.

### Deposition conditions

(i)Film forming gas
   TEOS flow rate: 50 sccm
   N₂O flow rate: 50 sccm
   NH₃ flow rate (parameter): 0 to 250 sccm Gas pressure: approximately 1.0 Torr
(ii)Plasma excitation conditions
   Lower electrode
   Low frequency electric power (frequency: 380 kHz): 150 W
   Upper electrode
   High frequency electric power (frequency: 13.56 MHz): 0 W
(iii)Substrate heating conditions: 375°C

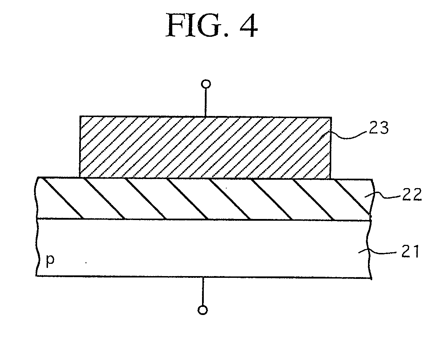

Fig. 4 is the cross-sectional view showing the sample for investigation. In the drawing, reference numeral 21 denotes the Si substrate as the substrate subject to deposition, 22: the insulating film formed by the deposition method of the present invention, and 23: the electrode.
(a) Relative Dielectric constant of film deposited
   Investigation was made for the dielectric constant of the insulating film deposited under the foregoing deposition conditions and by changing the ammonia flow rate in the range of 0 to 250 sccm. The film shown in Fig. 4 was used as the sample for investigation.

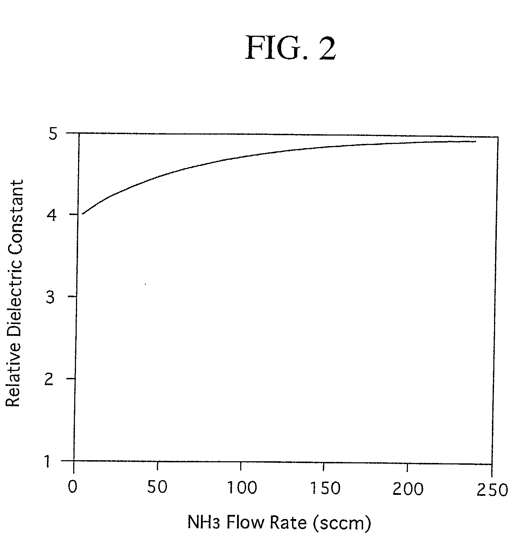

   Fig. 2 is the graph showing the relationship between the relative dielectric constant of the insulating film deposited and the ammonia flow rate. The axis of ordinate shows the relative dielectric constant of the film deposited, which is expressed in a linear scale, and the axis of abscissas shows the ammonia flow rate (sccm) expressed in the linear scale.
   The relative dielectric constant was measured by a C-V measurement method, in which a signal having a frequency of 1 MHz is superposed to direct current bias.
   According to Fig. 2, the relative dielectric constant is about 4 at the ammonia flow rate of 0, it gradually increases as the ammonia flow rate increases and changes so as to gradually approximate to the relative dielectric constant of 5. Specifically, the relative dielectric constant in the 4 range can be at least obtained at the ammonia flow rate of 250 sccm or less.
(b) Leakage current of film deposited
   Investigation was made for the leakage current of the insulating film deposited under the foregoing deposition conditions and at the ammonia flow rate of 200 sccm. The film shown in Fig. 4 was used as the sample for investigation. The leakage current value relates to the density of the film deposited, by which the barrier characteristic against copper can be estimated.

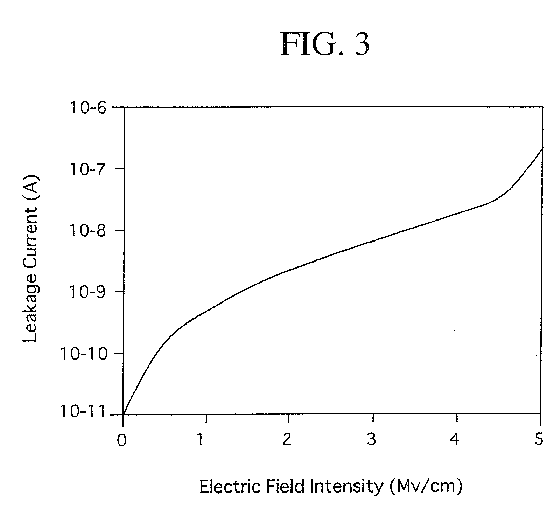

Fig. 3 is the view showing the relationship between a electric field intensity and the leakage current of the insulating film 22 when a voltage is applied between the substrate 21 and the electrode 23. The axis of ordinate shows the leakage current value (A) of the insulating film 22, which is expressed in the linear scale, and the axis of abscissas shows the electric field intensity (MV/cm) expressed in the linear scale.

According to Fig. 3, the leakage current is in the 10⁻¹⁰ A range at the electric field intensity of 1 MV/cm, and it is 10⁻⁶ A at the electric field intensity of 5 MV/cm, where a sufficiently small leakage current was obtained. This shows that the film deposited is dense and diffusion preventing capability against copper is high.

As described, according to the first embodiment, the dense insulating film having the relative dielectric constant of 5 or less and in the 4 range, which is low comparing to the relative dielectric constant of about 7 of the silicon nitride film, was obtained.

Although the relative dielectric constant needs to be further reduced in order to use the insulating film as a main inter layer dielectric between the copper wirings, for example, the insulating film is most suitable for using as the barrier insulating film that coats the copper wiring, making use of its characteristics of relatively low relative dielectric constant and high diffusion preventing capability.

### (Second Embodiment)

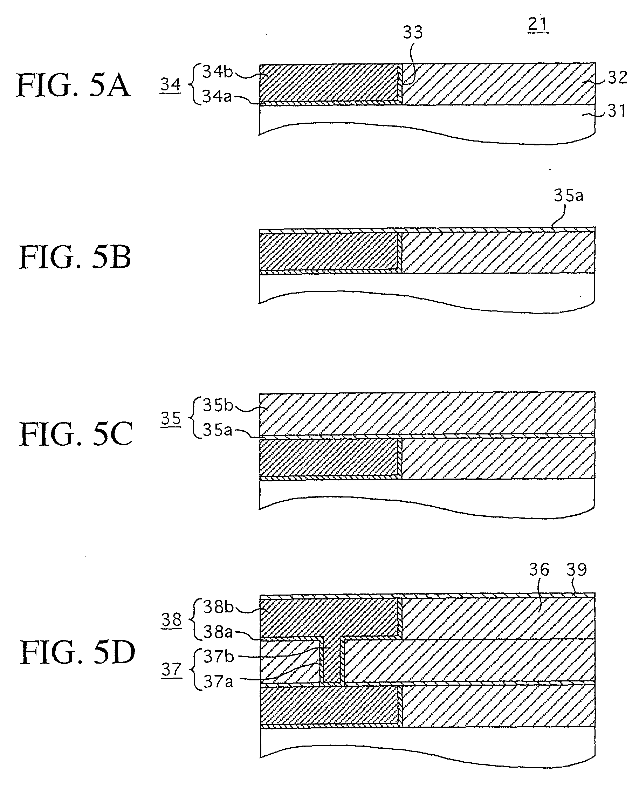

Description will be made for the semiconductor device and manufacturing method thereof according to the second embodiment of the present invention with reference to Figs. 5A to 5D.

Figs. 5A to 5D are the cross-sectional views showing the manufacturing method of the semiconductor device according to the second embodiment of the present invention. TEOS+N₂O+NH₃ are used as the film forming gas.

Firstly, a substrate 31 having a front-end insulating film formed on a surface thereof is prepared as shown in Fig. 5A. A lower wiring buried insulating film 32 formed of an SiO₂ film with the film thickness of about 1µm having low relative dielectric constant from 2 to the 3 range is formed on the substrate 31 by a well-known method.

Subsequently, as shown in Fig. 5A, a TaN film 34a as a copper diffusion preventing film is formed on an inner surface of a wiring groove 33 after the lower wiring buried insulating film 32 is etched to form the wiring groove 33. Then, after forming a copper seed layer (not shown) on the surface of the TaN film 34a by a sputtering method, a copper film is buried thereon by a plating method.

Thereafter, the copper film and the TaN film 34a protruded from the wiring groove 33 are polished by a CMP method (Chemical Mechanical Polishing method) to make the surface flat. Thus, a lower wiring 34 formed of the copper wiring 34b and the TaN film 34a is formed.

The ones described above constitute the substrate subject to deposition 21.

Next, as shown in Fig. 5B, a barrier insulating film 35a formed of a PE-CVD SiO₂ film having the film thickness of about a few tens nm is formed by the plasma enhanced CVD method using TEOS+N₂O+NH₃ on the lower wiring buried insulating film 32 while coating the copper wiring 34b that is exposed from the lower wiring buried insulating film 32.

Subsequently, as shown in Fig. 5C, a main insulating film 35 formed of the PE-CVD SiO₂ film having low relative dielectric constant from 2 to the 3 range is formed on the barrier insulating film 35a by a well-known method. The barrier insulating film 35a and the main insulating film 35b constitute the inter wiring layer insulating film 35.

Details of the deposition method of the inter wiring layer insulating film 35 will be described as follows.

Specifically, to form the inter wiring layer insulating film 35, the substrate subject to deposition 21 is introduced into a chamber 1 of the deposition apparatus 101 to be held by a substrate holder 3. Then, the substrate subject to deposition 21 is heated and its temperature is kept at 375°C.

Next, TEOS, N₂O gas and NH₃ are introduced at the flow rate of 50 sccm, 50 sccm and 200 sccm respectively into the chamber 1 of the plasma enhanced deposition apparatus 101 shown in Fig. 1, and the pressure is kept at about 1.0 Torr.

Then, the low frequency electric power of about 150 W (electric power density: about 0.18 W/cm²) having the frequency of 380 kHz is applied to the lower electrode 3. At this point, the high frequency electric power (frequency: 13.56 MHz) is not applied to the upper electrode 2.

TEOS, N₂O and NH₃ are thus transformed into plasma. This status is maintained for thirty seconds to form the barrier insulating film 35a formed of the PE-CVD SiO₂ film having the film thickness of about 10 to 50nm.

A porous insulating film 35b having the film thickness of about 500nm, which is the main insulating film, is subsequently formed on the barrier insulating film 35a.

As described above, the inter wiring layer insulating film 35 that consists of the barrier insulating film 35a and the main insulating film 35b is formed.

Next, as shown in Fig. 5D, an upper wiring buried insulating film 36 formed of the SiO₂ film having the film thickness of about 500nm is formed on the inter wiring layer insulating film 35 by the same method used in forming the lower wiring buried insulating film 32.

Then, a connection conductor 37 and an upper wiring 38, which is mainly formed of a copper film, are formed by a well-known dual-damascene method. Note that reference numerals 37a and 38a in the drawing denote the TaN film, and 37b and 38b denote the copper film.

Next, a barrier insulating film 39 formed of the PE-CVD SiO₂ is formed on the entire surface using the same deposition method as the one used in forming the barrier insulating film 35a. Thus, the semiconductor device is completed.

As described above, according to the second embodiment, in the manufacturing method of the semiconductor device in which the inter wiring layer insulating film 35 is sandwiched between the lower wiring buried insulating film 32, in which the lower wiring 34 is buried, and the upper wiring buried insulating film 36, in which the upper wiring 38 is buried, the plasma enhanced CVD method using TEOS+N₂O+NH₃ forms the barrier insulating film 35a that coats the copper film 34b, which constitutes the lower wiring 34.

Therefore, the barrier insulating film 35a having the relative dielectric constant in the 4 range, which is low comparing to the relative dielectric constant of about 7 of the silicon nitride film, and high diffusion preventing capability against copper can be obtained. Thus, with intervention of the inter wiring layer insulating film including the barrier insulating film 35a, a multi-layer copper wiring can be formed while restricting excessive increase of parasitic capacitance and maintaining the diffusion preventing capability against copper.

With this configuration, the semiconductor integrated circuit device that can deal with higher data transfer speed along with higher integration can be provided.

As in the foregoing, although the present invention has been described in detail based on the embodiments, the scope of the present invention is not limited to the examples specifically shown in the embodiments. Changes of the foregoing embodiments within the scope of the spirit of the present invention are included in the scope of the present invention.

For example, hydrocarbon is not contained in the film forming gas in the second embodiment. However, hydrocarbon, which is any one of methane (CH₄), acetylene (C₂H₂), ethylene (C₂H₄), and ethane (C₂H₆) for example can be contained in the film forming gas as described in the first embodiment. In this case, hydrocarbon (CₘHₙ): any one of methane (CH₄), acetylene (C₂H₂), ethylene (C₂H₄), and ethane (C₂H₆) is added to the film forming gas other than tetraethoxysilane and nitrogen monoxide, or tetraethoxysilane, nitrogen monoxide and ammonia (NH₃).

Alternatively, inert gas containing any one of helium (He), argon (Ar) and nitrogen (N₂) may be contained in the film forming gas.

In the present invention, the film forming gas containing tetraethoxysilane (TEOS) and nitrogen monoxide (N₂O) is transformed into plasma to cause reaction, and the barrier insulating film is thus formed on the substrate subject to deposition. Accordingly, the barrier insulating film having diffusion preventing capability against copper while maintaining the relatively low relative dielectric constant in the 4 range can be formed.

Moreover, addition of ammonia (NH₃) to the film forming gas of the barrier insulating film can improve the diffusion preventing capability against copper.

Furthermore, with addition of hydrocarbon (CₘHₙ): any one of methane (CH₄), acetylene (C₂H₂), ethylene (C₂H₄), and ethane (C₂H₆) for example, other than tetraethoxysilane and nitrogen monoxide, or tetraethoxysilane, nitrogen monoxide and ammonia (NH₃) to the film forming gas of the barrier insulating film, the barrier insulating film with higher diffusion preventing capability against copper can be obtained while maintaining low relative dielectric constant.

Accordingly, with intervention of the inter wiring layer insulating film including the barrier insulating film, the multi-layer copper wirings can be formed while restricting excessive increase of parasitic capacitance and maintaining the diffusion preventing capability against copper. The semiconductor integrated circuit device that can deal with higher data transfer speed along with higher integration and density can be thus provided.

## Claims

1. A manufacturing method of a semiconductor device, comprising the steps of:
transforming film forming gas containing tetraethoxysilane (TEOS) and nitrogen monoxide (N₂O) into plasma to cause reaction; and
forming a barrier insulating film (35a, 39) that coats copper wiring (34, 38) on a substrate (31) where said copper wiring (34, 38) is exposed on a surface thereof.

2. The manufacturing method of a semiconductor device according to claim 1, wherein
said film forming gas further contains at least one of ammonia (NH₃) and nitrogen (N₂) other than tetraethoxysilane (TEOS) and nitrogen monoxide (N₂O).

3. The manufacturing method of a semiconductor device according to claim 1, wherein
said film forming gas further contains hydrocarbon (CₘHₙ) other than tetraethoxysilane (TEOS) and nitrogen monoxide (N₂O).

4. The manufacturing method of a semiconductor device according to claim 3, wherein
said hydrocarbon (CₘHₙ) is any one of methane (CH₄), acetylene (C₂H₂), ethylene (C₂H₄), and ethane (C₂H₆).

5. The manufacturing method of a semiconductor device according to claim 2, wherein
said film forming gas further contains hydrocarbon (CₘHₙ) other than tetraethoxysilane (TEOS), nitrogen monoxide (N₂O), and at least any one of ammonia (NH₃) and nitrogen (N₂).

6. The manufacturing method of a semiconductor device according to claim 5, wherein
said hydrocarbon (CₘHₙ) is any one of methane (CH₄), acetylene (C₂H₂), ethylene (C₂H₄), and ethane (C₂H₆).
